# EUROPEAN PATENT APPLICATION

(11) **EP 3 518 302 A1**
(43) Date of publication of application: **31.07.2019**
(21) Application number: 17853065.5
(22) Date of filing: 20.09.2017
(51) Int. Cl.: H01L 51/44

(54) **SOLAR CELL**

(30) Priority: 21.09.2016 JP 2016184375
(71) Applicant: Sekisui Chemical Co., Ltd., Osaka-shi, Osaka 530-0047 (JP)
(72) Inventor: HAYAKAWA, Akinobu, Mishima-gun Osaka 618-0021 (JP); YUKAWA, Mayumi, Mishima-gun Osaka 618-0021 (JP); KUREBAYASHI, Tetsuya, Mishima-gun Osaka 618-0021 (JP); UNO, Tomohito, Mishima-gun Osaka 618-0021 (JP); ASANO, Motohiko, Mishima-gun Osaka 618-0021 (JP); FUKUMOTO, Yuuichirou, Tsukuba-shi Ibaraki 300-4247 (JP); AITA, Tetsuya, Mishima-gun Osaka 618-0021 (JP); MORITA, Takeharu, Mishima-gun Osaka 618-0021 (JP)
(74) Representative: Cabinet Beau de Loménie
(86) International application number: PCT/JP2017/033858
(87) International publication number: WO 2018/056295

(57) **Abstract**

The present invention aims to provide a solar cell having high photoelectric conversion efficiency that is less likely to decrease even under application of a voltage for a long period of time. Provided is a solar cell including: a cathode; a photoelectric conversion layer; and an anode in the stated order, the photoelectric conversion layer including an organic-inorganic perovskite compound represented by the formula: R-M-X₃ wherein R represents an organic molecule, M represents a metal atom, and X represents a halogen or chalcogen atom, the solar cell further including, between the photoelectric conversion layer and the anode layer, a diffusion prevention layer including at least one selected from the group consisting of: metal oxides, metal nitrides, and metal oxynitrides each containing a group 6 to 15 metal in the periodic table; and carbon.

## Description

### TECHNICAL FIELD

The present invention relates to a solar cell having high photoelectric conversion efficiency that is less likely to decrease even under application of a voltage for a long period of time.

### BACKGROUND ART

Solar cells including a laminate (photoelectric conversion layer) having an N-type semiconductor layer and a P-type semiconductor layer disposed between opposing electrodes have been conventionally developed. Such solar cells generate photocarriers (electron-hole pairs) by photoexcitation so that electrons and holes move through the N-type semiconductor and the P-type semiconductor, respectively, to create an electric field.

Most solar cells currently in practical use are inorganic solar cells which are produced using inorganic semiconductors made of silicon or the like. The inorganic solar cells, however, are utilized only in a limited range because their production is costly and upsizing thereof is difficult. Therefore, organic solar cells produced using organic semiconductors instead of inorganic semiconductors (see Patent Literatures 1 and 2, for example) and organic-inorganic solar cells produced using organic semiconductors and inorganic semiconductors in combination have received attention.

Fullerene is used in most organic solar cells and organic-inorganic solar cells. Fullerene is known to function mainly as an N-type semiconductor. For example, Patent Literature 3 discloses a semiconductor heterojunction film formed using an organic compound serving as a P-type semiconductor, and a fullerene. Fullerene, however, is known to be responsible for degradation of organic solar cells or organic-inorganic solar cells produced using the fullerene (see Non-Patent Literature 1, for example). Thus, a material that can replace fullerene is desired.

Recently, a photoelectric conversion material having a perovskite structure containing lead, tin, or the like as a central metal, called as an organic-inorganic hybrid semiconductor, has been found and proved to have high photoelectric conversion efficiency (see Non-Patent Literature 2, for example).

### CITATION LIST

### - Patent Literature

Patent Literature 1: JP 2006-344794 A
Patent Literature 2: JP 4120362 B
Patent Literature 3: JP 2006-344794 A

### - Non-Patent Literature

Non-Patent Literature 1: Reese et al., Adv. Funct. Mater., 20, 3476-3483 (2010)
Non-Patent Literature 2: M. M. Lee et al., Science, 338, 643-647 (2012)

### SUMMARY OF INVENTION

### - Technical Problem

The present invention aims to provide a solar cell having high photoelectric conversion efficiency that is less likely to decrease even under application of a voltage for a long period of time.

### - Solution to problem

The present invention relates to a solar cell including: a cathode; a photoelectric conversion layer; and an anode in the stated order, the photoelectric conversion layer including an organic-inorganic perovskite compound represented by the formula: R-M-X₃ wherein R represents an organic molecule, M represents a metal atom, and X represents a halogen or chalcogen atom, the solar cell further including, between the photoelectric conversion layer and the anode, a diffusion prevention layer including at least one selected from the group consisting of: metal oxides, metal nitrides, and metal oxynitrides each containing a group 6 to 15 metal in the periodic table; and carbon.

The present invention is specifically described in the following.

The use of a specific organic-inorganic perovskite compound in a photoelectric conversion layer in a solar cell that includes a cathode, a photoelectric conversion layer, and an anode in the stated order is expected to improve the photoelectric conversion efficiency. However, the present inventors found out that the photoelectric conversion efficiency is high immediately after the production of the solar cell but decreases under application of a voltage to the solar cell for a long period of time. The present inventors presumed that application of a voltage to the solar cell for a long period of time causes diffusion of an anode material (metal) in the photoelectric conversion layer containing an organic-inorganic perovskite compound and such diffusion possibly lowers the photoelectric conversion efficiency.

The present inventors considered providing, between the photoelectric conversion layer and the anode, a diffusion prevention layer including at least one selected from the group consisting of: metal oxides, metal nitrides, and metal oxynitrides each containing a group 6 to 15 metal in the periodic table; and carbon. The present inventors found out that the presence of such a diffusion prevention layer can prevent diffusion of an anode material (metal) in the photoelectric conversion layer containing an organic-inorganic perovskite compound so that the solar cell can maintain high photoelectric conversion efficiency even under application of a voltage for a long period of time. Thus, the present invention was completed.

The solar cell of the present invention includes a cathode, a photoelectric conversion layer, and an anode in the stated order.

The term "layer" as used herein means not only a layer having a clear boundary, but also a layer having a concentration gradient in which contained elements are gradually changed. The elemental analysis of the layer can be conducted, for example, by FE-TEM/EDS analysis of a cross section of the solar cell to confirm the element distribution of a particular element. The term "layer" as used herein means not only a flat thin-film layer, but also a layer capable of forming an intricate structure together with other layer(s).

The material of the cathode is not particularly limited, and a conventionally known material may be used. In the solar cell of the present invention, the anode may be made of a metal as described later. In this case, the cathode is preferably a transparent electrode.

Examples of the cathode material include fluorine-doped tin oxide (FTO), tin-doped indium oxide (ITO), sodium, sodium-potassium alloys, lithium, magnesium, aluminum, magnesium-silver mixtures, magnesium-indium mixtures, aluminum-lithium alloys, Al/Al₂O₃ mixtures, and Al/LiF mixtures. These materials may be used alone or in combination of two or more.

The photoelectric conversion layer contains an organic-inorganic perovskite compound represented by the formula R-M-X₃ wherein R represents an organic molecule, M represents a metal atom, and X represents a halogen or chalcogen atom. A solar cell including the photoelectric conversion layer that contains the organic-inorganic perovskite compound is referred to as an organic-inorganic hybrid solar cell.

The use of the organic-inorganic perovskite compound in the photoelectric conversion layer can improve the photoelectric conversion efficiency of the solar cell.

R is an organic molecule and is preferably represented by CₗNₘHₙ (l, m, and n each represent a positive integer).

Specific examples of R include methylamine, ethylamine, propylamine, butylamine, pentylamine, hexylamine, dimethylamine, diethylamine, dipropylamine, dibutylamine, dipentylamine, dihexylamine, trimethylamine, triethylamine, tripropylamine, tributylamine, tripentylamine, trihexylamine, ethylmethylamine, methylpropylamine, butylmethylamine, methylpentylamine, hexylmethylamine, ethylpropylamine, ethylbutylamine, formamidine, acetoamidine, guanidine, imidazole, azole, pyrrole, aziridine, azirine, azetidine, azete, imidazoline, carbazole and their ions (e.g., methylammonium(CH₃NH₃)), and phenethylammonium. Among them, preferred are methylamine, ethylamine, propylamine, butylamine, pentylamine, hexylamine, formamidine, acetoamidine and their ions, and phenethylammonium, and more preferred are methylamine, ethylamine, propylamine, formamidine and their ions.

M is a metal atom. Examples thereof include lead, tin, zinc, titanium, antimony, bismuth, nickel, iron, cobalt, silver, copper, gallium, germanium, magnesium, calcium, indium, aluminum, manganese, chromium, molybdenum, and europium. These metal atoms may be used alone or in combination of two or more.

X is a halogen or chalcogen atom. Examples thereof include chlorine, bromine, iodine, sulfur, and selenium. These halogen or chalcogen atoms may be used alone or in combination of two or more. Among them, a halogen atom is preferred because the organic-inorganic perovskite compound containing halogen in the structure is soluble in an organic solvent and is usable in an inexpensive printing method or the like. In addition, iodine is more preferred because the organic-inorganic perovskite compound has a narrower energy band gap.

The organic-inorganic perovskite compound preferably has a cubic crystal structure where the metal atom M is placed at the body center, the organic molecule R is placed at each vertex, and the halogen or chalcogen atom X is placed at each face center.

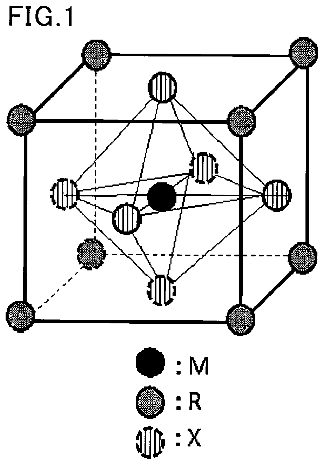

Fig. 1 is a schematic view illustrating an exemplary crystal structure of the organic-inorganic perovskite compound having a cubic crystal structure where the metal atom M is placed at the body center, the organic molecule R is placed at each vertex, and the halogen atom or chalcogen atom X is placed at each face center. Although details are not clear, it is presumed that the direction of an octahedron in the crystal lattice can be easily changed owing to the structure; thus the mobility of electrons in the organic-inorganic perovskite compound is enhanced, improving the photoelectric conversion efficiency of the solar cell.

The organic-inorganic perovskite compound is preferably a crystalline semiconductor. The crystalline semiconductor means a semiconductor whose scattering peak can be detected by the measurement of X-ray scattering intensity distribution. In the case where the organic-inorganic perovskite compound is a crystalline semiconductor, the mobility of electrons in the organic-inorganic perovskite compound is enhanced, leading to improvement of the photoelectric conversion efficiency of the solar cell.

The degree of crystallinity can also be evaluated as an index of crystallization. The degree of crystallinity can be determined by separating a crystalline substance-derived scattering peak from an amorphous portion-derived halo, which are detected by X-ray scattering intensity distribution measurement, by fitting, determining their respective intensity integrals, and calculating the ratio of the crystalline portion to the whole.

The lower limit of the degree of crystallinity of the organic-inorganic perovskite compound is preferably 30%. When the degree of crystallinity is 30% or higher, the mobility of electrons in the organic-inorganic perovskite compound is enhanced, improving the photoelectric conversion efficiency of the solar cell. The lower limit of the degree of crystallinity is more preferably 50%, still more preferably 70%.

Examples of the method for increasing the degree of crystallinity of the organic-inorganic perovskite compound include thermal annealing, irradiation with strong-intensity light, such as laser, and plasma irradiation.

The photoelectric conversion layer may further contain an organic semiconductor or an inorganic semiconductor, in addition to the organic-inorganic perovskite compound, as long as the effect of the present invention is not impaired. The organic semiconductor or inorganic semiconductor herein may serve as a hole transport layer or an electron transport layer, respectively.

Examples of the organic semiconductor include compounds having a thiophene skeleton, such as poly(3-alkylthiophene). The examples also include conductive polymers having a poly-p-phenylenevinylene skeleton, a polyvinylcarbazole skeleton, a polyaniline skeleton, a polyacetylene skeleton, or the like. The examples further include: compounds having a phthalocyanine skeleton, a naphthalocyanine skeleton, a pentacene skeleton, a porphyrin skeleton such as a benzoporphyrin skeleton, a spirobifluorene skeleton or the like; and carbon-containing materials such as carbon nanotube, graphene, and fullerene which may be surface-modified.

Examples of the inorganic semiconductor include titanium oxide, zinc oxide, indium oxide, tin oxide, gallium oxide, tin sulfide, indium sulfide, zinc sulfide, CuSCN, Cu₂O, CuI, MoO₃, V₂O₅, WO₃, MoS₂, MoSe₂, and Cu₂S.

The photoelectric conversion layer containing the organic-inorganic perovskite compound and the organic semiconductor or inorganic semiconductor may be a laminate where a thin-film organic semiconductor or inorganic semiconductor part and a thin-film organic-inorganic perovskite compound part are stacked, or may be a composite film where an organic semiconductor or inorganic semiconductor part and an organic-inorganic perovskite compound part are combined. The laminate is preferred from the viewpoint that the production process is simple. The composite film is preferred from the viewpoint that the charge separation efficiency of the organic semiconductor or inorganic semiconductor can be improved.

The lower limit of the thickness of the thin-film organic-inorganic perovskite compound part is preferably 5 nm and the upper limit thereof is preferably 5,000 nm. When the thickness is 5 nm or more, the thin-film organic-inorganic perovskite compound part can sufficiently absorb light to improve the photoelectric conversion efficiency. When the thickness is 5,000 nm or less, formation of a region in which charge separation cannot be achieved can be suppressed, leading to higher photoelectric conversion efficiency. The lower limit of the thickness is more preferably 10 nm and the upper limit thereof is more preferably 1,000 nm. The lower limit of the thickness is still more preferably 20 nm and the upper limit thereof is still more preferably 500 nm.

In the case where the photoelectric conversion layer is a composite film where an organic semiconductor or inorganic semiconductor part and an organic-inorganic perovskite compound part are combined, the lower limit of the thickness of the composite film is preferably 30 nm and the upper limit thereof is preferably 3,000 nm. When the thickness is 30 nm or more, light can be sufficiently absorbed, leading to higher photoelectric conversion efficiency. When the thickness is 3,000 nm or less, charge easily arrives at the electrode, leading to higher photoelectric conversion efficiency. The lower limit of the thickness is more preferably 40 nm and the upper limit thereof is more preferably 2,000 nm. The lower limit of the thickness is still more preferably 50 nm and the upper limit thereof is still more preferably 1,000 nm.

The photoelectric conversion layer may be formed by any method. Examples of the method include a vacuum evaporation method, a sputtering method, a chemical vapor deposition method (CVD), an electrochemical sedimentation method, and a printing method. Among these, employment of a printing method enables simple formation of a large-area solar cell that can exhibit high photoelectric conversion efficiency. Examples of the printing method include a spin coating method and a casting method. Examples of the method using the printing method include a roll-to-roll method.

The anode may be produced from any material, and a conventionally known material may be used. Even in the case where the anode material is one (metal) easily diffusible in the photoelectric conversion layer containing the organic-inorganic perovskite compound, a later-described diffusion prevention layer provided between the photoelectric conversion layer and the anode in the solar cell of the present invention can prevent diffusion of the anode material (metal) in the photoelectric conversion layer containing the organic-inorganic perovskite compound. This allows the solar cell to maintain high photoelectric conversion efficiency even under application of a voltage for a long period of time. Specifically, the anode may be made of a metal. The anode is often a patterned electrode.

Examples of the anode material include metals such as gold, silver, chromium, aluminum, titanium, platinum, and iridium. These materials may be used alone or in combination of two or more.

The solar cell of the present invention further includes, between the photoelectric conversion layer and the anode, a diffusion prevention layer including at least one selected from the group consisting of: metal oxides, metal nitrides, and metal oxynitrides each containing a group 6 to 15 metal in the periodic table; and carbon.

The presence of the diffusion prevention layer between the photoelectric conversion layer and the anode prevents diffusion of the anode material (metal) in the photoelectric conversion layer containing the organic-inorganic perovskite compound, thereby allowing the solar cell to maintain high photoelectric conversion efficiency even under application of a voltage for a long period of time.

The diffusion prevention layer refers to a layer preventing diffusion of the anode material (metal) in the photoelectric conversion layer containing the organic-inorganic perovskite compound. For this purpose, the diffusion prevention layer is preferably a continuous dense film, not a particle aggregate layer or a porous layer.

More specifically, the diffusion prevention layer preferably has a denseness and continuousness to the extent that upper and lower layers sandwiching the diffusion prevention layer are not in contact with each other at any part in transmission electron microscopic pictures taken at arbitrary ten sites in a cross section resulting from cutting of the solar cell with a focused ion beam (FIB). In other words, the diffusion prevention layer preferably has denseness and continuousness to the extent that the upper and lower layers sandwiching the diffusion prevention layer are apart from each other with the diffusion prevention layer present therebetween. In the case where the diffusion prevention layer is not a dense film, the photoelectric conversion efficiency of the solar cell may decrease or the photoelectric conversion efficiency of the solar cell may decrease under application of a voltage for a long period of time.

The transmission electron microscope may be, for example, JEM-2010-FEF (available from JEOL Ltd.).

The diffusion prevention layer is formed by, preferably, a dry film formation method (e.g., a vapor deposition method, sputtering, CVD) or by wet coating (e.g., spray coating, spin coating). Thus, a dense film can be formed.

The diffusion prevention layer includes at least one selected from the group consisting of: metal oxides, metal nitrides, and metal oxynitrides each containing a group 6 to 15 metal in the periodic table; and carbon.

The metal oxides, metal nitrides, and metal oxynitrides containing a group 6 to 15 metal in the periodic table each may contain one group 6 to 15 metal in the periodic table or two or more group 6 to 15 metals in the periodic table. Specific examples thereof include nickel oxide, molybdenum oxide, indium tin oxide (ITO), aluminum zinc oxide (AZO), gallium zinc oxide (GZO), chromium nitride, indium oxynitride, and aluminum oxynitride.

The metal oxides, metal nitrides, and metal oxynitrides each containing a group 6 to 15 metal in the periodic table and carbon are conductive, hole-transporting materials not adversely affecting the photoelectric conversion efficiency, and are less likely to be diffused in the photoelectric conversion layer containing the organic-inorganic perovskite compound than the anode material (metal). Among the metal oxides, metal nitrides, and metal oxynitrides each containing a group 6 to 15 metal in the periodic table and carbon, preferred are metal oxides containing a group 6 to 15 metal in the periodic table and carbon because they are less likely to lower the photoelectric conversion efficiency of the solar cell. More preferred are ITO, AZO, GZO, and carbon because they are highly conductive and less likely to lower the photoelectric conversion efficiency of the solar cell. Moreover, carbon is still more preferred because it has high transparency when having a thickness within a range preferred for preventing diffusion of the anode material (metal) and is comparatively inexpensive. ITO is also still more preferred because it has high transparency when having a thickness within a range preferred for preventing diffusion of the anode material (metal) and is highly conductive.

For prevention of diffusion of the anode material (metal), it is also conceivable that at least one selected from the group consisting of: the metal oxides, metal nitrides, and metal oxynitrides each containing a group 6 to 15 metal in the periodic table; and carbon is deposited as the anode, instead of providing the diffusion prevention layer.

However, in the case where at least one selected from the group consisting of: the metal oxides, metal nitrides, and metal oxynitrides each containing a group 6 to 15 metal in the periodic table; and carbon is used as the anode, the solar cell has higher resistance. In such a case, improvement of the photoelectric conversion efficiency as in the case of providing the diffusion prevention layer is hardly achieved.

The diffusion prevention layer may contain, in addition to at least one selected from the group consisting of: the metal oxides, metal nitrides, and metal oxynitrides each containing a group 6 to 15 metal in the periodic table; and carbon, other additives within a range that the effect of the present invention is not impaired.

The thickness of the diffusion prevention layer is not particularly limited. The lower limit of the thickness is preferably 10 nm and the upper limit thereof is preferably 5,000 nm. When the thickness is 10 nm or more, diffusion of the anode material (metal) can be sufficiently prevented, leading to higher photoelectric conversion efficiency. When the thickness is 5,000 nm or less, the diffusion prevention layer does not cause excessively high resistance, leading to higher photoelectric conversion efficiency, and also has higher transparency. The lower limit of the thickness is more preferably 50 nm and the upper limit thereof is more preferably 1,000 nm. The lower limit is still more preferably 100 nm and the upper limit is still more preferably 500 nm.

The solar cell of the present invention may have an electron transport layer between the cathode and the photoelectric conversion layer.

The material of the electron transport layer is not particularly limited, and examples thereof include N-type conductive polymers, N-type low-molecular organic semiconductors, N-type metal oxides, N-type metal sulfides, alkali metal halides, alkali metals, and surfactants. Specific examples thereof include cyano group-containing polyphenylene vinylene, boron-containing polymers, bathocuproine, bathophenanthroline, hydroxy quinolinato aluminum, oxadiazole compounds, and benzoimidazole compounds. The examples further include naphthalenetetracarboxylic acid compounds, perylene derivatives, phosphine oxide compounds, phosphine sulfide compounds, fluoro group-containing phthalocyanine, titanium oxide, zinc oxide, indium oxide, tin oxide, gallium oxide, tin sulfide, indium sulfide, and zinc sulfide.

The electron transport layer may consist only of a thin-film electron transport layer. Preferably, the electron transport layer includes a porous electron transport layer. In particular, in the case where the photoelectric conversion layer is a composite film in which an organic semiconductor or inorganic semiconductor part and an organic-inorganic perovskite compound part are combined, the composite film is preferably formed on a porous electron transport layer because a more complicated composite film (more intricate structure) can be obtained, leading to higher photoelectric conversion efficiency.

The lower limit of the thickness of the electron transport layer is preferably 1 nm and the upper limit thereof is preferably 2,000 nm. When the thickness is 1 nm or more, holes can be sufficiently blocked. When the thickness is 2,000 nm or less, the layer is less likely to be resistance to electron transport, leading to higher photoelectric conversion efficiency. The lower limit of the thickness of the electron transport layer is more preferably 3 nm and the upper limit thereof is more preferably 1,000 nm. The lower limit is still more preferably 5 nm and the upper limit is still more preferably 500 nm.

The solar cell of the present invention may have a hole transport layer between the photoelectric conversion layer and the diffusion prevention layer.

The material of the hole transport layer is not particularly limited, and the hole transport layer may include an organic material. Examples of the material of the hole transport layer include P-type conductive polymers, P-type low-molecular organic semiconductors, P-type metal oxides, P-type metal sulfides, and surfactants. Specific examples thereof include compounds having a thiophene skeleton, such as poly(3-alkylthiophene). The examples also include conductive polymers having a triphenylamine skeleton, a poly-p-phenylenevinylene skeleton, a polyvinylcarbazole skeleton, a polyaniline skeleton, a polyacetylene skeleton, or the like. The examples further include: compounds having a phthalocyanine skeleton, a naphthalocyanine skeleton, a pentacene skeleton, a porphyrin skeleton such as a benzoporphyrin skeleton, a spirobifluorene skeleton or the like; molybdenum sulfide, tungsten sulfide, copper sulfide, and tin sulfide; fluoro group-containing phosphonic acid and carbonyl group-containing phosphonic acid; and copper compounds such as CuSCN and CuI. In particular, preferred are P-type conductive polymers and P-type low-molecular organic semiconductors because the photoelectric conversion efficiency of the solar cell can be improved.

The hole transport layer may partly merge with the photoelectric conversion layer (it may form an intricate structure together with the photoelectric conversion layer) or disposed in the shape of a thin film on the photoelectric conversion layer. The lower limit of the thickness of the hole transport layer in the shape of a thin film is preferably 1 nm and the upper limit thereof is preferably 2,000 nm. When the thickness is 1 nm or more, electrons can be sufficiently blocked. When the thickness is 2,000 nm or less, the layer is less likely to be resistance to electron transport, leading to higher photoelectric conversion efficiency. The lower limit of the thickness is more preferably 3 nm and the upper limit thereof is more preferably 1,000 nm. The lower limit is still more preferably 5 nm and the upper limit is still more preferably 500 nm.

The solar cell of the present invention may further include a substrate or the like. The substrate is not particularly limited, and examples thereof include transparent glass substrates made of soda-lime glass, alkali-free glass, or the like, ceramic substrates, and transparent plastic substrates.

The solar cell of the present invention may be produced by any method. An exemplary method includes forming, on the substrate, the cathode, the electron transport layer, the photoelectric conversion layer, the hole transport layer, the diffusion prevention layer, and the anode in the stated order.

### - Advantageous Effects of Invention

The present invention can provide a solar cell having high photoelectric conversion efficiency that is less likely to decrease even under application of a voltage for a long period of time.

### BRIEF DESCRIPTION OF DRAWINGS

Fig. 1 is a schematic view illustrating an exemplary crystal structure of an organic-inorganic perovskite compound.

### DESCRIPTION OF EMBODIMENTS

The present invention is more specifically described with reference to, but not limited to, the following examples.

### (Example 1)

A 1,000 nm-thick FTO film was formed as a cathode on a glass substrate, and ultrasonically washed with pure water, acetone, and methanol each for 10 minutes in the stated order, and then dried.

A solution of titanium isopropoxide adjusted to 2% in ethanol was applied to the surface of the FTO film by a spin coating method, and fired at 400°C for 10 minutes. Thus, a thin-film electron transport layer with a thickness of 20 nm was formed. A titanium oxide paste containing polyisobutyl methacrylate as an organic binder and titanium oxide (mixture of those with an average particle size of 10 nm and those with an average particle size of 30 nm) was applied to the thin-film electron transport layer by a spin coating method, followed by firing at 500°C for 10 minutes. Thus, a porous electron transport layer with a thickness of 500 nm was formed.

Subsequently, lead iodide as a metal halide compound was dissolved in N,N-dimethylformamide (DMF) to prepare a 1 M solution. The obtained solution was applied onto the porous electron transport layer by a spin coating method to form a film, thereby preparing a sample. Separately, methylammonium iodide as an amine compound was dissolved into 2-propanol to prepare a 1 M solution. The sample with the above lead iodide film was immersed into this solution to form a layer containing CH₃NH₃PbI₃ which is an organic-inorganic perovskite compound. After the immersion, the obtained sample was subjected to heat treatment at 80°C for 30 minutes. Thus, a photoelectric conversion layer was formed.

Next, to the photoelectric conversion layer was applied a 9% by weight chlorobenzene solution of Spiro-OMeTAD (available from Merck) that is a low-molecular organic compound (P-type) by spin coating. Thus, a hole transport layer with a thickness of 200 nm was formed.

Then, on the hole transport layer was formed a 500 nm-thick diffusion prevention layer made of carbon by an electron beam vapor deposition method.

On the obtained diffusion prevention layer was formed a 100 nm-thick gold film as an anode by a resistive thermal deposition method. Thus, a solar cell including a laminate of a cathode/an electron transport layer/a photoelectric conversion layer/a hole transport layer/a diffusion prevention layer/an anode was obtained.

The obtained solar cell was cut with a focused ion beam (FIB), and the cut plane was observed using a transmission electron microscope (JEM-2010-FEF available from JEOL Ltd.). In transmission electron microscopic pictures taken at arbitrary ten sites, contact between the upper and lower layers sandwiching the diffusion prevention layer was not observed at any part, which confirmed that the diffusion prevention layer was a continuous dense film.

### (Examples 2 to 20)

A solar cell including a laminate of a cathode/an electron transport layer/a photoelectric conversion layer/a hole transport layer/a diffusion prevention layer/an anode was obtained as in Example 1, except that the types and thicknesses of the hole transport layer and diffusion prevention layer, and the anode were changed as shown in Table 1.

### (Comparative Examples 1 and 2)

A solar cell including a laminate of a cathode/an electron transport layer/a photoelectric conversion layer/a hole transport layer/a different layer/an anode was obtained as in Example 1, except that no diffusion prevention layer including carbon was formed and a TiO₂ dense film or ZrO₂ dense film with a thickness of 100 nm was formed as a different layer.

### (Comparative Examples 3 and 4)

A solar cell including a laminate of a cathode/an electron transport layer/a photoelectric conversion layer/a hole transport layer/a diffusion prevention layer (anode) was obtained as in Example 1, except that no anode was formed and a diffusion prevention layer including carbon and having a thickness of 500 nm or 2,000 nm as shown in Table 2 was formed (a diffusion prevention layer including carbon was used as an anode).

### (Comparative Examples 5 to 8)

A solar cell including a laminate of a cathode/an electron transport layer/a photoelectric conversion layer/a hole transport layer/an anode was obtained as in one of Examples 1 to 4, except that no diffusion prevention layer including carbon was formed.

### (Comparative Examples 9 to 11)

A solar cell including a laminate of a cathode/an electron transport layer/a photoelectric conversion layer/a hole transport layer/a different layer/an anode was obtained as in Example 4, except that no diffusion prevention layer including carbon was formed and a 500 nm-thick film of carbon nanotube, ITO nanoparticles, or carbon black (i.e., carbon nanoparticles) was formed as a different layer as shown in Table 2.

In the formation of a film of carbon nanotube, ITO nanoparticles, or carbon black, a dispersion of carbon nanotube, ITO nanoparticles, or carbon black was prepared using a ultrasonic homogenizer, and the obtained dispersion was applied by spin coating to form a film.

The obtained solar cell was cut with a focused ion beam (FIB) and the cut plane was observed using a transmission electron microscope (JEM-2010-FEF available from JEOL Ltd.) as in Example 1. In transmission electron microscopic pictures taken at arbitrary ten sites, contact between the upper and lower layers sandwiching the obtained film including carbon nanotube, ITO nanoparticles, or carbon black was observed at multiple parts.

### <Evaluation>

The solar cells obtained in the examples and comparative examples were evaluated as follows. Evaluation results are shown in Table 1 or 2.

### (1) Measurement of photoelectric conversion efficiency

A power source (model 236 available from Keithley Instruments Inc.) was connected between the electrodes of the solar cell immediately after the production of the solar cell. The photoelectric conversion efficiency was measured using a solar simulator (available from Yamashita Denso Corp.) at an intensity of 100 mW/cm². The obtained photoelectric conversion efficiency was taken as the initial conversion efficiency. The resulting photoelectric conversion efficiency values were standardized with the photoelectric conversion efficiency of the solar cell obtained in Comparative Example 5 set as a benchmark. ○○○ (Outstanding): Standardized initial conversion efficiency value was 0.9 or more.
○○ (Excellent): Standardized initial conversion efficiency value was 0.8 or more and less than 0.9.
○ (Good): Standardized initial conversion efficiency value was 0.7 or more and less than 0.8.
× (Poor): Standardized initial conversion efficiency value was less than 0.7.

### (2) Evaluation of durability under application of voltage for long period of time

A power source (model 236 available from Keithley Instruments Inc.) was connected between the electrodes of the solar cell. The photoelectric conversion efficiency was measured after application of a voltage at 25°C for 24 hours using a solar simulator (available from Yamashita Denso Corp.) at an intensity of 100 mW/cm².
○○ (Excellent): The photoelectric conversion efficiency after a lapse of 24 hours was 90% or higher relative to the initial conversion efficiency.
○ (Good): The photoelectric conversion efficiency after a lapse of 24 hours was 80% or higher and lower than 90% relative to the initial conversion efficiency.
× (Poor): The photoelectric conversion efficiency after a lapse of 24 hours was lower than 80% relative to the initial conversion efficiency.

**[Table 1]**

| | Anode | Diffusion prevention layer | | Different layer | | Hole transport layer | Photoelectric conversion efficiency | Durability under application of voltage for long priod of time |
|---|---|---|---|---|---|---|---|---|
| | | Type | Thickness | Type | Thickness | | | |
| Example 1 | Gold | Carbon | 500 nm | - | - | Spiro-OMeTAD* | ○○○ | ○○ |
| Example 2 | Silver | Carbon | 500 nm | - | - | Spiro-OMeTAD* | ○○○ | ○○ |
| Example 3 | Chromium | Carbon | 500 nm | - | - | Spiro-OMeTAD* | ○○○ | ○○ |
| Example 4 | Aluminum | Carbon | 500 nm | - | - | Spiro-OMeTAD* | ○○○ | ○○ |
| Example 5 | Titanium | Carbon | 500 nm | - | - | Spiro-OMeTAD* | ○○○ | ○○ |
| Example 6 | Titanium | ITO | 100 nm | - | - | Spiro-OMeTAD* | ○○○ | ○○ |
| Example 7 | Titanium | GZO | 100 nm | - | - | Spiro-OMeTAD* | ○○○ | ○○ |
| Example 8 | Gold | NiO | 100 nm | - | - | Spiro-OMeTAD* | ○ | ○○ |
| Example 9 | Gold | MoO₃ | 100 nm | - | - | Spiro-OMeTAD* | ○ | ○○ |
| Example 10 | Titanium | Carbon | 200 nm | - | - | Spiro-OMeTAD* | ○○○ | ○○ |
| Example 11 | Titanium | Carbon | 100 nm | - | - | Spiro-OMeTAD* | ○○○ | ○○ |
| Example 12 | Aluminum | Carbon | 100 nm | - | - | Spiro-OMeTAD* | ○○○ | ○○ |
| Example 13 | Aluminum | Carbon | 2000 nm | - | - | Spiro-OMeTAD* | ○○ | ○○ |
| Example 14 | Aluminum | Carbon | 5000 nm | - | - | Spiro-OMeTAD* | ○ | ○○ |
| Example 15 | Aluminum | Carbon | 40 nm | - | - | Spiro-OMeTAD* | ○○○ | ○○ |
| Example 16 | Aluminum | Carbon | 10 nm | - | - | Spiro-OMeTAD* | ○○○ | ○ |
| Example 17 | Aluminum | CrN | 100 nm | - | - | Spiro-OMeTAD* | ○ | ○○ |
| Example 18 | Aluminum | In(O,N) | 100 nm | - | - | Spiro-OMe TAD* | ○ | ○○ |
| Example 19 | Aluminum | Carbon | 100 nm | - | - | PTAA (Conductive polymer) | ○○○ | ○○ |
| Example 20 | Aluminum | Carbon | 100 nm | - | - | CuI | ○ | ○ |

| | | | | | | | | |
|---|---|---|---|---|---|---|---|---|
| * (Low-molecular organic semiconductor) | | | | | | | | |

**[Table 2]**

| | Anode | Diffusion prevention layer | | Different layer | | Hole transport layer | Photoelectric conversion efficiency | Durability under application of voltage for long priod of time |
|---|---|---|---|---|---|---|---|---|
| | | Type | Thickness | Type | Thickness | | | |
| Comparative Example 1 | Gold | - | - | TiO₂ dense film | 100 nm | Spiro-OMeTAD* | × | - |
| Comparative Example 2 | Gold | - | - | ZrO₂ dense film | 100 nm | Spiro-OMeTAD* | × | - |
| Comparative Example 3 | - | Carbon | 500 nm | - | - | Spiro-OMeTAD* | × | - |
| Comparative Example 4 | - | Carbon | 2000 nm | - | - | Spiro-OMeTAD* | × | - |
| Comparative Example 5 | Gold | - | - | - | - | Spiro-OMeTAD* | ○○○ | × |
| Comparative Example 6 | Silver | - | - | - | - | Spiro-OMeTAD* | × | × |
| Comparative Example 7 | Chromium | - | - | - | - | Spiro-OMeTAD* | × | - |
| Comparative Example 8 | Aluminum | - | - | - | - | Spiro-OMeTAD* | × | - |
| Comparative Example 9 | Aluminum | - | - | Carbon nanotube | 500 nm | Spiro-OMeTAD* | ○ | × |
| Comparative Example 10 | Aluminum | - | - | ITO nanoparticles | 500 nm | Spiro-OMeTAD* | × | × |
| Comparative Example 11 | Aluminum | - | - | Carbon black | 500 nm | Spiro-OMeTAD* | × | × |

| | | | | | | | | |
|---|---|---|---|---|---|---|---|---|
| * (Low-molecular organic semiconductor) | | | | | | | | |

### INDUSTRIAL APPLICABILITY

The present invention can provide a solar cell having high photoelectric conversion efficiency that is less likely to decrease even under application of a voltage for a long period of time.

## Claims

1. A solar cell comprising:
a cathode;
a photoelectric conversion layer; and
an anode in the stated order,
the photoelectric conversion layer comprising an organic-inorganic perovskite compound represented by the formula: R-M-X₃ wherein R represents an organic molecule, M represents a metal atom, and X represents a halogen or chalcogen atom,
the solar cell further comprising, between the photoelectric conversion layer and the anode, a diffusion prevention layer comprising at least one selected from the group consisting of: metal oxides, metal nitrides, and metal oxynitrides each containing a group 6 to 15 metal in the periodic table; and carbon.

2. The solar cell according to claim 1,
wherein the anode comprises a metal.

3. The solar cell according to claim 1 or 2,
wherein the cathode is a transparent electrode.

4. The solar cell according to claim 1, 2, or 3,
wherein the solar cell has a hole transport layer between the photoelectric conversion layer and the diffusion prevention layer, and the hole transport layer contains a P-type conductive polymer or P-type low-molecular organic semiconductor.
